# FASCICULE DE BREVET EUROPEEN

(11) **EP 0 213 974 B1**
(45) Date de publication et mention de la délivrance du brevet: **08.02.1995**
(21) Numéro de dépôt: 86401296.8
(22) Date de dépôt: 13.06.1986
(51) Int. Cl.: H01L 23/48, H01L 23/52, G06K 19/06

(54) **Micromodule à contacts enterrés et carte contenant des circuits comportant un tel micromodule**
Mikromodul mit eingebetteten Kontakten und Karte mit solchen Mikromodulschaltungen
Micromodule with embedded contacts and a card containing circuits comprising such a micromodule

(30) Priorité: 14.06.1985 FR 8509074
(43) Date de publication de la demande: 11.03.1987
(73) Titulaire: SGS-THOMSON MICROELECTRONICS S.A., 94253 Gentilly Cedex (FR)
(72) Inventeur: Gloton, Jean-Pierre, F-75008 Paris (FR); Peres, Philippe, F-75008 Paris (FR)
(74) Mandataire: Schmit, Christian Norbert Marie

(56) Documents cités:
- FR-A- 2 439 438
- GB-A- 2 149 209

## Description

La présente invention concerne un micromodule à contacts enterrés. Elle concerne aussi une carte de type CCC contenant des circuits comportant un tel micromodule. Elle trouve application dans les domaines du paiement électronique ou encore de la sécurité.

De l'art antérieur, il est connu de constituer sur une carte plastique une carte spéciale contenant un microcircuit électronique. Cette carte désignée sous le vocable CCC respecte un format standard décrivant les cartes de crédit. Le microcircuit peut être constitué par une mémoire inscriptible, une mémoire morte et jusqu'à un microordinateur dans le cas de cartes CCC de haut niveau. Il est connu de constituer la carte CCC en au moins deux parties. Une première partie est constituée par la carte plastique proprement dite. Une seconde partie est constituée par un micromodule comportant un support, des contacts électriques et au moins un microcircuit relié auxdits contacts et fixé au support.

Dans le brevet français 2.548.857, on a indiqué un procédé de fabrication d'un micromodule spécialement destiné à une fabrication en continu d'une carte imprimée tout à fait comparable au micromodule de l'invention. Le micromodule de l'art antérieur qui y est décrit comporte un substrat, des plages conductrices latérales et centrale ménagées sur la face externe du substrat. Mais la disposition décrite présente des inconvénients. En effet, une fois le micromodule installé sur la carte plastique proprement dite, selon cet état de l'art, le microcircuit installé sur le substrat est invisible de l'extérieur. Aussi on trouve de l'extérieur vers l'intérieur de la carte tout d'abord les parties conductrices constituant notamment les contacts, un substrat par exemple de genre PVC puis le microcircuit relié par des fils aux zones conductrices latérales. Un puits creusé à l'intérieur du substrat PVC permet de coller le microcircuit sur la face interne de la partie conductrice centrale. Les fils de raccordement du microcircuit sont disposés à l'intérieur de perforations transversales du substrat et fixés sur les plages conductrices latérales. De telles cartes sont soumises à des risques de détérioration des parties métalliques. En effet on notera que les dimensions de la carte sont très faibles. Le film métallique est de l'ordre de 60 microns d'épaisseur. En opération, la carte est introduite dans un lecteur. Les contacts sont reliés au lecteur par un connecteur par frottement. Au retrait de la carte, les contacts étant chauds, il existe un risque de détérioration des contacts. Un autre inconvénient de cette disposition réside en ce que la carte est destinée à être manipulée dans des conditions parfois extremes. En particulier la carte peut être tordue, ce qui constitue un risque de décollement des parties métalliques. Afin de porter remède à ces inconvénients de l'art antérieur tout en ménageant les avantages d'une construction en continu de micromodules, l'invention propose un micromodule tel que défini dans les revendications 1 et 4. Dans ce micromodule, les parties conductrices sont disposées sur la face interne d'un support plastique. Un microcircuit est disposé sur la face interne d'une partie conductrice centrale et des fils de connexion de ce microcircuit à des parties conductrices latérales sont prévues. Des perforations dans le support plastique permettent de ménager des zones de contact dans des endroits prédéterminés.

On notera par ailleurs qu'il est connu du document FR 2 439 438, un micromodule dans lequel les parties conductrices servant de contacts de la carte sont disposées sur la face externe du support plastique et sont donc soumis aux risques de détérioration que l'invention évite.

On remarquera que l'invention permet aussi d'éviter de percer un puits central dans le support plastique pour loger le microcircuit sur la face interne du métal central.

L'invention concerne aussi une carte telle que définie dans la revendication 5.

D'autres avantages et caractéristiques de la présente invention seront mieux compris à l'aide de la description et des figures annexées qui sont :
- la figure 1 une coupe schématique d'un micromodule constitué selon l'art antérieur,
- la figure 2 un schéma de montage d'un micromodule sur une carte CCC,
- la figure 3 une coupe schématique d'un micromodule selon l'invention.

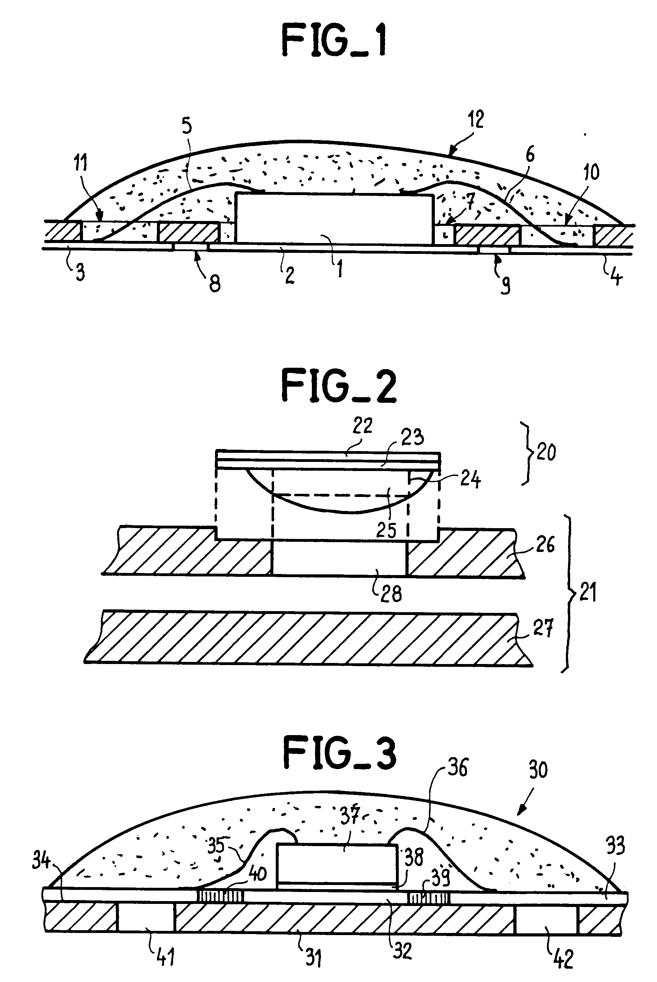

A la figure 1 on a représenté un micromodule constitué selon l'art antérieur. Un microcircuit 1 est disposé sur un film métallique 2. Le film métallique est constitué initialement par une bande gravée de façon à aménager une partie centrale 2 qui reçoit le microcircuit 1 et des parties latérales 3, 4, qui recevront les extrêmités de connexions 5, 6 de la puce. La bande métallique 2 - 4 est collée sur la face externe d'un film plastique constituant un support matériel au micromodule. Ce film plastique est percé de deux genres de trous. Un premier genre de trous est constitué par un trou 7 ou puits dans lequel est disposé le microcircuit 1. Ce puits est obligatoire dans ce procédé de l'art antérieur pour ménager une connexion arrière du microcircuit. C'est notamment le cas des microcircuits à polarisation de substrat, silicium notamment. Un autre genre de perçage est constitué par les perçage 10 et 11 qui permettent d'amener les fils de connexions 6 et 5 aux parties conductrices latérales 3 et 4. Les fils conducteurs 5, 6 sont fixés par soudage ou collage sur la face interne de la bande conductrice. A la fin du procédé de montage, la face interne du micromodule, supérieure sur le dessin, est noyée dans une perle de résine de protection 12 déposée à chaud. En utilisant des matériaux PVC pour le film et la résine de protection, on obtient une bonne constitution mécanique du microcircuit.

A la figure 2 on a représenté l'opération d'encartage du micromodule. Le micromodule 20 constitué des parties conductrices de contact externe 22, du support 23 et de la goutte de résine 25 est tout d'abord mise en forme selon les traits pointillés 24 de manière à pouvoir se placer sur une cale en plastique 26. La puce et la goutte de résine sont formées selon le pointillé 24 par usinage et viennent se disposer dans le logement 28 de la cale 26. L'embase 27 est réalisée dans le même matériau que la cale 26. L'ensemble peut être assemblé par collage ou encore par chauffage. La carte 21 comporte donc trois parties principales : un micromodule 20, une cale 26 et une embase 27.

A la figure 3, on a représenté un micromodule constitué selon l'invention. Contrairement à l'art antérieur, le film plastique qui constitue le support du micromodule est disposé à l'extérieur de la carte après encartage. Sur sa face interne, est disposée la bande conductrice constituée en parties conductrices centrale 32 et latérales 33 et 34. Le microcircuit 37 est disposé sur la partie centrale 32 et les fils de connexions 35 et 36 sont soudés ou fixés directement sur la face interne des parties conductrices latérales 33, 34. A ce niveau de la description, on constate immédiatement que le procédé de montage électrique ne requièrt aucune manipulation ni aucun façonnage du support plastique 31.

Les zones conductrices 32, 33 et 34 sont séparées par des parties isolantes 39, 40 au dessin. Dans la réalité un standard s'est dégagé selon lequel huit contacts sont prévus. Il faut donc découper huit parties conductrices distinctes. Chaque partie conductrice dans un mode d'exécution est séparée de la suivante par une partie isolante comme la partie 39 ou la partie 40 de la figure 3. Les parties isolantes peuvent être des simples découpes entre parties conductrices ou encore des barrettes isolantes. Dans un mode d'exécution on choisit des parties électriquement isolantes 39, 40 ayant un rôle de dissipation de l'énergie thermique dégagée par le circuit. Dans un autre mode de réalisation, les parties isolantes sont des découpes réalisées par photogravure d'une bande métallique. Un procédé de découpe par photogravure assure la possibilité d'une fabrication continue du micromodule.

Le microcircuit 37 dans un mode de réalisation est disposé sur la partie centrale conductrice 32 par l'intermédiaire d'une couche de colle conductrice 38. Dans un autre mode de réalisation, la partie centrale conductrice 32 est constituée par une métallisation de la face arrière du microcircuit 37. Une telle façon est particulièrement intéressante quand le microcircuit comporte un substrat par exemple en silicium dopé qu'il faut polariser par une électrode de face arrière de substrat.

Dans le standard qui régit la constitution des cartes CCC au format "carte de crédit", la localisation des contacts est prédéterminée. L'invention a ceci de remarquable qu'elle permet d'ajuster cette zone de contacts uniquement par perçage d'un film plastique 31. Dans un autre mode de réalisation, les perçages 41, 42, qui sont au standard habituel au nombre de huit, sont munis d'une métallisation qui favorise la lecture des contacts qui sont enterrés à l'intérieur du film support.

Dans un mode de réalisation, les parties conductrices 32 - 34 sont fixées au support plastique 31 par collage. Dans un autre mode de réalisation, les parties conductrices sont fixées au support par chauffage ou par pressage.

Le micromodule de l'invention est particulièrement adapté à constituer un composant d'une carte contenant un circuit d'un type CCC.

## Revendications

1. Micromodule destiné à être monté dans une carte contenant un microcircuit, comprenant un film de support principal en matière plastique (31) ayant une face interne et une face externe, la face interne étant noyée dans la carte après encartage du micromodule et la face externe étant disposée vers l'extérieur de la carte après encartage, des parties conductrices centrale (32) et latérales (33, 34) étant déposées sur la face interne du film, un microcircuit électronique (37) étant disposé sur la partie conductrice centrale du côté de la carte et étant connecté aux parties conductrices latérales par des fils de connexion (35, 36), caractérisé en ce qu'il comprend des perforations d'accès (41, 42) ménagées dans le film en regard des parties conductrices latérales pour ménager des zones de contact à travers les perforations d'accès.

2. Micromodule selon la revendication 1, caractérisé en ce que les parties conductrices sont réalisées par découpe d'un ruban métallique qui est ensuite collé ou pressé sur le film de support.

3. Micromodule selon l'une des revendications précédentes, caractérisé en ce que les perforations d'accès sont métallisées.

4. Micromodule destiné à être monté dans une carte contenant un microcircuit, comprenant un film de support principal en matière plastique (31) ayant une face interne et une face externe, la face interne étant noyée dans la carte après encartage du micromodule et la face externe étant disposée vers l'extérieur de la carte après encartage, des parties conductrices latérales étant déposées sur la face interne du film et une partie conductrice centrale étant constituée par une métallisation de la face arrière d'un microcircuit (37) disposé sur le film du côté de la carte et connecté aux parties latérales conductrices par des fils de connexion caractérisé en ce qu'il comprend des perforations d'accès (41,42) ménagées dans le film en regard des parties conductrices latérales pour ménager des zones de contact à travers les perforations d'accès.

5. Carte comportant un microcircuit, caractérisée en ce qu'elle comporte un micromodule selon l'une des revendications précédentes, les parties conductrices latérales étant accessibles à partir de la face externe du film de support.

## Patentansprüche

1. Mikromodul, bestimmt zur Anbringung in einer Karte, die eine Mikroschaltung enthält, aufweisend einen Hauptträgerfilm aus Kunststoffmaterial (31), der eine Innenseite und eine Außenseite aufweist, wobei die Innenseite nach Einstecken des Mikromoduls in die Karte versenkt ist und die Außenseite nach Einstecken zur Außenseite der Karte angeordnet ist, wobei zentrale (32) und seitliche (33, 34) leitende Teile auf der Innenseite des Films aufgebracht sind, wobei eine elektronische Mikroschaltung (37) auf dem zentralen leitenden Teil der Seite der Karte angeordnet ist und mit den seitlichen leitenden Teilen durch Verbindungsdrähte (35, 36) verbunden ist, dadurch **gekennzeichnet**, daß es Zugangslöcher (41, 42) aufweist, die in dem Film gegenüber den seitlichen leitenden Teilen vorgesehen sind, um Kontaktzonen durch die Zugangsöffnungen vorzusehen.

2. Mikromodul nach Anspruch 1, dadurch **gekennzeichnet**, daß die leitenden Teile durch Schneiden eines metallischen Bandes ausgeführt sind, das anschließend auf den Trägerfilm geklebt oder gedrückt wird.

3. Mikromodul nach einem der vorhergehenden Ansprüche, dadurch **gekennzeichnet**, daß die Zugangsöffnungen metallisiert sind.

4. Mikromodul, bestimmt zur Anbringung in einer Karte, die eine Mikroschaltung enthält, aufweisend einen Hauptträgerfilm aus Kunststoffmaterial (31), der eine Innenseite und eine Außenseite aufweist, wobei die Innenseite nach Einstecken des Mikromoduls in die Karte versenkt ist und die Außenseite nach Einstecken zur Außenseite der Karte angeordnet ist, wobei seitliche leitende Teile auf der Innenseite des Films angeordnet sind und ein zentraler leitender Teil aus einer Metallisierung der Rückseite einer Mikroschaltung (37) besteht, die auf dem Film der Seite der Karte vorgesehen ist und mit den leitenden seitlichen Teilen durch Verbindungsdrähte verbunden ist, dadurch **gekennzeichnet**, daß es Zugangsöffnungen (41, 42) aufweist, die gegenüber seitlichen leitenden Teilen im Film vorgesehen sind, um Kontaktzonen durch die Zugangsöffnungen vorzusehen.

5. Karte, umfassend eine Mikroschaltung, dadurch **gekennzeichnet**, daß sie ein Mikromodul nach einem der vorhergehenden Ansprüche umfaßt, wobei die seitlichen leitenden Teile ausgehend von der Außenseite des Trägerfilms zugänglich sind.

## Claims

1. Micromodule intended to be mounted in a card containing a microcircuit, comprising a plastic main support film (31) having an inner face and an outer face, the inner face being embedded in the card after insertion of the micromodule and the outer face being deposited towards the outside of the card after insertion, central (32) and lateral (33, 34) conductive parts being deposited on the inner face of the film, an electronic microcircuit (37) being disposed on the central conductive part on the same side as the card and being connected to the lateral conductive parts by connecting wires (35, 36), characterised in that it comprises access perforations (41, 42) provided in the film opposite the lateral conductive parts in order to provide contact areas through the access perforations.

2. Micromodule according to Claim 1, characterised in that the conductive parts are produced by cutting out a metal strip which is then bonded to or pressed onto the support film.

3. Micromodule according to one of the preceding claims, characterised in that the access perforations are metallised.

4. Micromodule intended to be mounted in a card containing a microcircuit, comprising a plastic main support film (31) having an inner face and an outer face, the inner face being embedded in the card after insertion of the micromodule and the outer face being disposed towards the outside of the card after insertion, lateral conductive parts being deposited on the inner face of the film, and a central conductive part being formed by metallisation of the rear face of a microcircuit (37) disposed on the film on the same side as the card and connected to the lateral conductive parts by connecting wires, characterised in that it comprises access perforations (41, 42) formed in the film opposite the lateral conductive parts in order to form contact areas through the access perforations.

5. Card including a microcircuit, characterised in that it includes a micromodule according to one of the preceding claims, the lateral conductive parts being accessible from the outer face of the support film.
